# EUROPEAN PATENT APPLICATION

(11) **EP 1 925 652 A1**
(43) Date of publication of application: **28.05.2008**
(21) Application number: 07075961.8
(22) Date of filing: 01.11.2007
(51) Int. Cl.: C09K 11/77, C09K 11/84

(54) **Fluorescent substance containing glass sheet, method for manufacturing the glass sheet and light-emitting device**

(30) Priority: 01.11.2006 JP 2006297846
(71) Applicant: NEC Lighting, Ltd., Shinagawa-ku Tokyo 141-0032 (JP)
(72) Inventor: Minamoto, Maki, c/o NEC Lighting, Ltd., Tokyo 141-0032 (JP); Yoshimatsu, Ryo, c/o NEC Lighting, Ltd., Tokyo 141-0032 (JP)
(74) Representative: Wenzel & Kalkoff

(57) **Abstract**

The present invention has an object to provide a fluorescent substance containing glass sheet which suppresses attenuation of intensity of wavelength converted light emitted by a sulfide fluorescent substance, is able to increase the life of the light emitting device, and does not bring about environmental pollution by lead, its manufacturing method and a light-emitting device using this. A fluorescent substance containing glass sheet formed by mixing an oxide-coated fluorescent substance particle with glass powder that does not substantially include lead, and sintering them, the oxide-coated fluorescent substance particle having been produced by coating a surface of a sulfide fluorescent substance particle, which is excited by light emission from a light-emitting element and which emits wavelength converted light, with an oxide, wherein attenuation of intensity of said wavelength converted light emitted by said sulfide fluorescent substance particle is suppressed by a forming process.

## Description

### BACKGROUND OF THE INVENTION

### Field of the Invention

The present invention relates to a fluorescent substance containing glass sheet, a method for manufacturing the glass sheet, and a light emitting device using the glass sheet.

### Description of the Related Art

Light-emitting diodes (LEDs) emitting blue/ultraviolet light of a wavelength of something close to 400 nm have long lives. LED elements using them are used for illumination light sources and various displays. A white light- emitting LED element includes fluorescent substances which are excited by the light emitted by the LED and emits wavelength converted light of, for example, greenish yellow color, orange color and the like with different wavelengths, and thereby mixes color with blue/ultraviolet light emitted from the LED to emit white light. As a fluorescent substance used in such an LED element, a sulfide fluorescent substance is excellent as an excited fluorescent substance since it emits fluorescence of green to red with high intensity with near ultraviolet/blue light as an exciting source. More specifically, a sulfide fluorescent substance emits fluorescence with equivalent intensity or more as compared with a YAG fluorescent substance frequently used as a fluorescent substance which emits fluorescence of greenish yellow color with light emitted from a blue/ultraviolet LED as an exciting source. However, a sulfide fluorescent substance easily receives environmental damage of moisture, oxygen and the like, reduces in light emitting characteristics, has a short life and shortens the long life of an LED element. Further, not only a sulfide fluorescent substance itself deteriorates, but also a sulfur content in the sulfide fluorescent substance corrodes the metal of the current-carrying part of the LED element, and causes reduction in light extraction efficiency in the LED element and breakage of the current-carrying part, so the life of the LED element is shortened. In order to increase the life of the LED element using a sulfide fluorescent substance, methods for suppressing deterioration of sulfide fluorescent substance are offered. More specifically, a method in which the surface of the above described sulfide fluorescent substance is coated with a silica film (Patent Document 1), a method in which it is micro-encapsulated by an organic coating film (Patent Document 2), and the like are reported. However, in all of them, it is difficult to coat the fluorescent substance surfaces completely, and a satisfactory method which can suppress deterioration of a sulfide fluorescent substance itself and deterioration of an LED element is not yet obtained.

When the coat is formed to be sufficiently thick to suppress deterioration of a sulfide fluorescent substance to a satisfactory degree for the above reason, there arises the problem that an incidence quantity of light from an exciting source on the fluorescent substance is reduced and a light emission quantity itself of the fluorescent substance is reduced.

When a fluorescent substance is resin-molded and used, deterioration of the resin easily occurs due to irradiation of a blue light-emitting diode since the blue light emitted by a LED has high energy. Fluorescent substances are also molded in glass instead of a resin. Further, in order to suppress deterioration of fluorescent substances by being exposed to a high temperature when they are molded in glass, a lead oxide and a bismuth oxide are contained in the glass to lower the softening point. However, fluorescent substances themselves react to lead or the like and glass, and darkening occurs to reduce light emitting efficiency. In order to avoid this, a luminescent color converting member which is designed to increase the life by adopting oxide fluorescent substances as the fluorescent substances molded in glass including a softening point at 500° or higher is reported (Patent Document 3). Further, a luminescent color converting member in which fluorescent substance particles coated by glass which does not include lead or bismuth are molded in glass including lead or bismuth is reported (Patent Document 4). However, when they are molded in glass including lead or bismuth, unless the coat of glass which does not include lead or bismuth is thick, it is difficult to suppress reaction of lead, bismuth or the like contained in the glass and sulfide fluorescent substances in a sintering-process at the time of molding a glass sheet, and the intensity of the original fluorescence of the sulfide fluorescent substance is reduced.
Patent Document 1:Japanese Patent Laid-Open No. 2002-69442
Patent Document 2:Japanese Patent Laid-Open No. 2003-46141
Patent Document 3:Japanese Patent Laid-Open No. 2003-258308
Patent Document 4:Japanese Patent Laid-Open No. 2006-52345

### SUMMARY OF THE INVENTION

An object of the present invention is to provide a fluorescent substance containing glass sheet which suppresses deterioration of a sulfide fluorescent substance in an environment by moisture, oxygen and the like and in a forming process, and by being used in a light emitting device such as an LED element using a blue/ultraviolet light-emitting diode, enables emission of white light with high intensity from a light emitting device, and a method for manufacturing the same. Further, an object of the present invention is to provide a fluorescent substance containing glass sheet which suppresses corrosion of electrodes or the like of a light emitting device by a sulfide fluorescent substance, makes the light-emitting device have a long life and does not bring about environmental pollution by lead and a method for manufacturing the same, and a light emitting device using the same.

The present inventors paid attention to suppression of deterioration which a sulfide fluorescent substance suffers in a manufacturing process of a glass sheet, and conducted research. Deterioration which a sulfide fluorescent substance particle suffers when being contained in the glass sheet includes deterioration due to the environment such as water and oxygen as a result of being exposed to a high temperature and deterioration by reaction with lead, bismuth and the like contained in glass to lower a melting point of the glass. When a sulfide fluorescent substance is used as an oxide-coated particle, a glass sheet is produced by using the oxide-coated fluorescent substance particle and glass powder which does not substantially contain lead and bismuth, whereby the sulfide fluorescent substance can be contained in the glass sheet without suffering deterioration due to reaction with substances contained in the glass powder and with deterioration by water, oxygen and the like being suppressed. The present inventor obtained the knowledge that by the above, attenuation of the wavelength conversion intensity of the sulfide fluorescent substance in the forming process was able to be suppressed, and completed the present invention.

Specifically, the present invention relates to a fluorescent substance containing glass sheet formed by mixing an oxide-coated fluorescent substance particle with glass powder that does not substantially include lead, and sintering them, the oxide-coated fluorescent substance particle having been produced by coating a surface of a sulfide fluorescent substance particle, which is excited by light emission from a light-emitting element and which emits wavelength converted light, with an oxide,
wherein attenuation of intensity of said wavelength converted light emitted by said sulfide fluorescent substance particle is suppressed by a forming process.

Further, the present invention relates to a method for manufacturing a fluorescent substance containing glass sheet, comprising a forming process in which an oxide-coated fluorescent substance particle produced by coating a surface of a sulfide fluorescent substance particle which is excited by luminescence from a light-emitting element and which emits wavelength converted light, with an oxide, and glass powder that does not substantially include lead are mixed and sintered,
wherein attenuation of intensity of said wavelength converted light emitted by said sulfide fluorescent substance particle is suppressed by said forming process.

The present invention relates to a light-emitting device, wherein said fluorescent substance containing glass sheet is used.

The fluorescent substance containing glass sheet of the present invention suppresses deterioration of a sulfide fluorescent substance in the environment by moisture, oxygen and the like, and a forming process, and by being used in a light-emitting device and the like using a blue/ultraviolet light-emitting diode, white light with high intensity can be emitted from the light-emitting device. Further, the fluorescent substance containing glass sheet of the present invention suppresses corrosion of electrodes and the like of the light-emitting device by the sulfide fluorescent substance, can increase the life of the light-emitting device, and does not bring about environmental pollution by lead.

The manufacturing method of the fluorescent substance containing glass sheet of the present invention can manufacture a glass sheet which suppresses deterioration of a sulfide fluorescent substancein the environment by moisture, oxygen and the like, and a forming process, and by being used in a light-emitting device such as an LED element and the like using a blue/ultraviolet light-emitting diode, can emit white light with high intensity from the light-emitting device, further suppresses corrosion of electrodes and the like of the light-emitting device by the sulfide fluorescent substance, can increase the life of the light-emitting device, and does not bring about environmental pollution by lead.

The light-emitting device of the present invention can emit white light with high intensity, suppresses deterioration of the sulfide fluorescent substance by the environment, corrosion of electrodes and the like of the light-emitting device by the sulfide fluorescent substance, can increase life, and does not bring about environmental pollution by lead.

### BRIEF DESCRIPTION OF THE DRAWINGS

FIG. 1 is a schematic configuration view showing one example of a fluorescent substance containing glass sheet of the present invention.
FIG. 2 is a schematic configuration view showing one example of a light-emitting device of the present invention.
FIG. 3 is a schematic configuration view showing another example of the light-emitting device of the present invention.
FIG. 4 is a schematic configuration view showing another example of the light-emitting device of the present invention.
FIG. 5 is a schematic configuration view showing another example of the light-emitting device of the present invention.

The Description of the Code
1,11,21,31,41:Fluorescent substance containing glass sheet
2:Oxide-coated fluorescent substance particle
3:Glass
12:Casing
13,23,33,44 : LED
14,24,45 : Transparent resin
15,46:Wiring
22:Metal stem
25:Metal post
32,42:Substrate
34:Optical member
43:Lead

### DETAILED DESCRIPTION OF THE PREFERRED EMBODIMENTS

A fluorescent substance containing glass sheet formed by mixing an oxide-coated fluorescent substance particle with glass powder that does not substantially include lead, and sintering them, the oxide-coated fluorescent substance particle having been produced by coating a surface of a sulfide fluorescent substance particle, which is excited by light emission from a light-emitting element and which emits wavelength converted light, with an oxide, wherein attenuation of intensity of said wavelength converted light emitted by said sulfide fluorescent substance particle is suppressed by a forming process.

The sulfide fluorescent substance particles used in the fluorescent substance-containing glass sheet of the present invention are excited by light emission from a light emitting element and emit wavelength converted light. As the sulfide fluorescent substance particles, particles of SrGa₂S₄, CaGa₂S₄, SrS, CaS, (Sr, Ca, Ba, Mg)Ga₂S₄, and (Sr, Ca, Ba)S activated with Eu, and the like can be cited in concrete. The particle sizes of these particles may be any size, and the average particle size may be 1 to 30 µm, for example. As the average particle size, the measurement value by a measurement method such as dry particle size distribution, wet particle size distribution, and a direct observation method by an electron microscope can be adopted.

As a light-emitting element which can be an excitation source of these sulfide fluorescent substance particles, a light-emitting diode, a laser diode, other solid light-emitting elements such as an inorganic electroluminescence can be cited, and for example, a light-emitting diode which emits blue/ultraviolet light can be cited. More specifically, a blue light-emitting diode of a gallium nitride such as InGaN, a zinc oxide and the like, which emits light of a wavelength of 440 to 480 nm is preferable. The wavelength converted light which the above-described sulfide fluorescent substance particles emit by excitation light emitted from such a blue light-emitting diode is visible light of green to red of 505 to 700 nm in concrete.

As an oxide which is used to form oxide-coated fluorescent substance particles by coating the surfaces of the above-described sulfide fluorescent substance particles, oxides such as a silicon oxide, an yttrium oxide, an aluminum oxide, or a lanthanum oxide can be cited. One kind of these oxides can be used, or two kinds or more of these oxides can be used in combination. Of these oxides, a silicon oxide has high affinity in mixing with glass powder for forming into a glass sheet, and is especially preferable.

The thickness of the oxide coat of the sulfide fluorescent substance is preferably such a thickness as can suppress deterioration by environment such as water and oxygen and characteristic degradation in a heating and pressurizing process at a time of forming glass sheet, and does not suppress excitation of a sulfide fluorescent substance by the excitation light. More specifically, 20 to 800 nm can be cited, and the thickness is preferably 20 to 500 nm. When the thickness of the coating is 20 nm or more, deterioration of the sulfide fluorescent substances at the time of forming the glass sheet in the post process can be suppressed, and when it is 800 nm or less, hindrance to incidence of the excitation light into the sulfide fluorescent substance particles can be suppressed. When the thickness of the coat is 20 to 500 nm, the above-described effect can remarkably be obtained.

As the coating ratio with respect to the surface of the sulfide fluorescent substance particle with an oxide is preferably 75% to 100%, more preferably 85% to 100%, and further more preferably 90% to 100%. The above-described thickness of the coat is the theoretical value which is obtained when the fluorescent substance particle is assumed to be completely spherical under the precondition that the coating ratio is 100%. The particle shape differs depending on the kind of sulfide fluorescent substance materials, and the actual sulfide fluorescent substance particles are not in complete particle shapes, but distortion occurs. Therefore, in order to bring the coating ratio as close to 100% as possible, the coating thickness is actually increased or decreased. As a result that the oxide coat is formed on the surface of the sulfide fluorescent substance particle by 75% or more, deterioration at the time of forming can be suppressed.

In order to form such an oxide-coated fluorescent substance particle, a CVD method, a PVD method, a solution method and the like can be used. As a CVD method, a plasma CVD method in which source gas is changed into plasma and an oxide coat is formed on the surface of a sulfide fluorescent substance particle can be cited. Reactive gas such as oxygen gas is supplied into a reaction tube which has a vacuum degree of about 0.05 to 5 Torr, for example, and this is placed in a plasma region where a radio frequency coil and the like are disposed, and is changed into plasma. Meanwhile, reactive gas such as tetramethyl silane gas is supplied into a reaction tube, and is caused to react with oxygen in a plasma state to form silica. The silica is deposited on the surfaces of the sulfide fluorescent substance particles disposed in the reaction tube outside the plasma region, and oxide-coated fluorescent substance particles are formed.

Further, as a solution method, a method in which a metal alkoxide solution prepared from lower fatty acid salt of yttrium, aluminum, or the like, for example, propionate and ethanol is used can be cited. Sulfide fluorescent substance particles are dispersed in the metal alkoxide solution, heated in accordance with necessity, then the coat of a desired thickness is formed and oxide-coated fluorescent substance particles can be formed. A medium is removed from the dispersion liquid by a spray dryer, and the oxide-coated fluorescent substance particles can be obtained.

The oxide-coated fluorescent substance particles can also be formed by using a solution obtained by mixing ethanol, water and ammonia into tetraethoxysilane, as in the case of using the above-described metal alkoxide solution.

Glass powder which is mixed with the above-described oxide-coated fluorescent substance particles does not substantially contain lead, bismuth and the like. Therefore, environmental pollution by these heavy metals can be suppressed, and deterioration of the sulfide fluorescent substance by a heavy metal such as lead can be suppressed even when the forming temperature is high. The case of substantially containing no lead includes the case of containing lead to such an extent that does not reach a content which can substantially lower the softening point of glass powder, and is, for example, 1000 ppm or lower in concrete. As for bismuth, the quantity which substantially contain no bismuth is the same as described above.

As glass powder, powder of silica glass, borosilicate glass, zinc borosilicate glass and the like can be cited. Glass powder with high density having a high enclosing effect of oxide-coated fluorescent substance particles is preferable since it can suppress deterioration of sulfide fluorescent substances. The glass powder of which melting temperature is low is preferable since it can suppress deterioration of the sulfide fluorescent substances at the time of forming. As glass powder, those containing silicic acid, boric anhydride, boric acid, and/or borax anhydride as main components are preferable.

The size of glass powder is not especially limited, and the size of glass powder is preferably in a range in which oxide-coated fluorescent substance particles can be uniformly dispersed. For example, 150 µm or less can be cited as the maximum particle size, and 10 to 20 µm or the like can be cited as the average particle size.

As for the mixing ratio of the above-described oxide-coated fluorescent substance particle and glass powder, the ratio of the oxide-coated fluorescent substance particle is preferably 1 to 10 mass% with respect to glass powder. When the ratio of the oxide-coated fluorescent substance particle is 1 mass% or more with respect to glass powder, white light can be made by mixing the color with blue color from the LED or so, and when the ratio is 10 mass% or less, white light can be made by suppressing intensity of luminescent color from the fluorescent substance. It is preferable to adjust scattering of light in the glass sheet and promote emission of white light by adjusting the mixing ratio by reducing the mixture ratio of oxide-coated fluorescent substance particles when the glass sheet is thick, and by increasing the mixture ratio of the oxide-coated fluorescent substance particles when it is thin.

In the mixture, a required binder and the like can be mixed in accordance with the forming method of the glass sheet. As the binder, any binder may be used if only it is dispersed throughout glass powder and oxide-coated fluorescent substance particles and is decomposed and removed at the time of sintering, and for example, a resin including proper viscosity can be used. In addition, a substance or the like which lowers the melting temperature of the glass can be contained in the mixture, in the range without inhibiting the functions of the oxide-coated fluorescent substance particles and glass powder.

Forming of the above described mixture may be any method of a molding method, a coating method and the like. For example, a method in which a preliminary molded body is produced by using a mold and is sintered thereafter, a method in which a coating film is formed on a board or directly on a member of an LED element as a coating liquid, and is sintered thereafter, or the like can be cited. The sintering temperature can be properly selected depending on the materials, and the temperature needs to be such a temperature as can melt particles of glass powder sufficiently to allow the oxide-coated fluorescent substance particles to be dispersed. For example, 370 to 650°C or the like can be cited, and 400 to 500°C is preferable. Even when the sintering temperature is high, deterioration by water, oxygen and the like can be suppressed by the oxide coat on the surface of the sulfide fluorescent substance particles.

As the shape of the glass sheet, desired shapes such as a film shape, a plate shape, and a curved shape can be cited. As the thickness of the glass sheet, a range of the thickness in which required dispersion is achieved and white light can be emitted can be properly selected in accordance with light emission intensity of the light- emitting element in use and the wavelength converted light intensity of the sulfide fluorescent substance and the like. For example, the thickness can be made 0.2 mm or more.

When the glass sheet is placed in an LED element via a support member such as a reflector, a support member is placed in a mold to be in a similar state as the state placed in the LED, for example, and the mixture can be injected into a molding cavity and integrated with the support member to be molded. As the support member, any of ceramics, a metal, a resin and the like may be adopted, for example.

In the oxide-coated fluorescent substance particle containing glass sheet thus obtained, attenuation of the intensity of the wavelength converted light of the sulfide fluorescent substance is suppressed in the forming process. The attenuation quantity of the intensity of the wavelength converted light of the sulfide fluorescent substance is specifically 20 to 5%, preferably 17 to 5%, more preferably 15 to 5%, and further more preferably 12 to 5%. Attenuation of the intensity of the wavelength converted light emitted from the sulfide fluorescent substance changes depending on the oxide coating ratio of the sulfide fluorescent substance particle, the heating temperature at the time of molding and the like. Attenuation of the intensity of the wavelength converted light emitted from the oxide coated fluorescent substance particles when at least 500 hours elapse after the glass sheet is placed under the environment at a high temperature with high humidity after forming is within 5% as compared with that shortly after forming.

Here, for the attenuation of the intensity of the wavelength converted light of the sulfide fluorescent substance, the value which can be obtained by the following measuring method can be adopted in the comparison with YAG fluorescent substances which are recognized to suffer no deterioration by an environment or heat. As the YAG fluorescent substance used in a white light emitting LED element, a Ce-activated (Y, Gd)₃(Al, Ga)₅₀₁₂ fluorescent substance of yellow light emission (hereinafter, called YAG fluorescent substance) can be used by comparison. The YAG fluorescent substance suffers less deteriorate at the time of producing a device by heating at 500°C or higher, and suffers extremely less deterioration from the environment.

Fluorescent substance powder is put into a box-shaped container, blue light from a blue LED is irradiated from the direction of 45°, for example, to a fluorescent substance surface formed by pressing the surface with a predetermined jig so as to be flat, and the fluorescence from the fluorescent substance powder enters on a spectrometer (made by Hamamatsu Photonics K.K.: Multichannel Spectrometer PMA-11) disposed in the vertical direction to measure the emission spectrum characteristic. At this time, the highest light emission intensity (hereinafter, called the light emission peak) of the light emission spectrum are compared. The light emission peak measurement value of the YAG fluorescent substance is set as 100, the measurement value of the light emission peak of the sulfide fluorescent substance particle before coated with an oxide is converted, and the converted value (100S) is obtained. For example, in the case of SrGa₂S₄, the converted value is 246. After the sulfide fluorescent substance is coated with an oxide of thickness of 500 µm, the light emission peak is similarly measured, and the light emission peak of the oxide-coated fluorescent substance particle is obtained (100S·(1-S1):S1 expresses the attenuation ratio by formation of oxide coating). For example, in the case of SrGa₂S₄, 230 is obtained. From these measurement values, the attenuation ratio S1 is 0.065, and attenuation of the sulfide fluorescent substance particle by formation of the oxide coating is about 6.5%.

Next, by using YAG fluorescent substances and oxide-coated fluorescent substance particles, the glass sheets of the same thickness are formed respectively. The glass sheets are placed on the light emission surface of a blue LED, and light emission from the glass sheets is measured with a spectrometer (made by StellarNet Inc.: Multichannel spectrometer EPP2000C) disposed above the glass sheets. The measurement value of the light emission peak intensity from the glass sheet containing the YAG fluorescent substance is set as 100a, the conversion value is obtained from the measurement value of the emission light peak from the glass sheet containing the oxide-coated fluorescent substance (100aS·(1-S1)·(1-S2):S2 expresses the attenuation ratio by the glass sheet forming). For example, in the case of a silicon oxide of SrGa₂S₄, 217 is obtained. From these measurement values, an attenuation ratio S2 is 0.057, and the attenuation of the sulfide fluorescent substance particle by forming glass sheet is about 5.7%. As the attenuation ratio ((1-S1)·(1-S2)) of the sulfide fluorescent substance particle in the glass sheet forming process, (1-0.065)·(1-0.057)=0.118 is obtained, and the attenuation of the wavelength converted light intensity of the sulfide fluorescent substance particle in the forming process is about 11.2%.

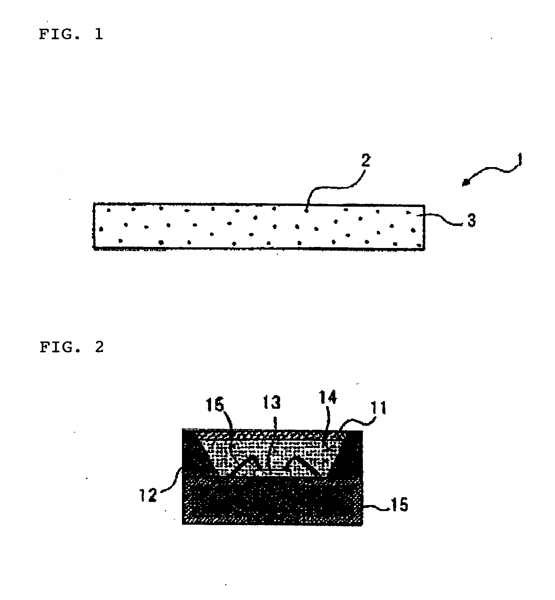

As a concrete example of the fluorescent substance containing glass sheet of the present invention, the one shown in a schematic side view of FIG. 1 can be cited. A fluorescent substance containing glass sheet 1 shown in FIG. 1 is the one which oxide-coated sulfide fluorescent substance particles 2 are dispersed in a glass 3.

A method for manufacturing a fluorescent substance containing glass sheet of the present invention is characterized by comprising a forming process in which an oxide-coated fluorescent substance particle produced by coating a surface of a sulfide fluorescent substance particle which is excited by luminescence from a light-emitting diode and which emits wavelength converted light, with an oxide, and glass powder that does not substantially include lead are mixed and sintered, wherein attenuation of intensity of said wavelength converted light emitted by said sulfide fluorescent substance particle is suppressed by said forming process.

A light-emitting device of the present invention is characterized in that the above described fluorescent substance containing glass sheet is used.

As one example of the light-emitting device of the present invention, the one shown in a schematic configuration view in FIG. 2 can be cited. The light-emitting device shown in FIG. 2 is mainly provided with a casing 12 having the function of a reflector, a light- emitting diode(LED) 13 which is fixed on a submount (not shown) fixed to the casing, a transparent resin 14 encircling the LED 13 and the above-described fluorescent substance containing glass sheet 11 to cover the transparent resin. The LED 13 preferably has the above-described LED such as a gallium nitride compound semiconductor and the like which is made by stacking an InGaN light-emitting layer on the substrate of Al₂O₃ or SIO and emits blue light. The LED has its electrodes wire-bonded by wiring 15 and is electrically connected to a power source not shown, and emits blue/ultraviolet light.

The above-described transparent resin is provided for protection of the LED, is excellent in transmitting property of emitted light from the LED, and has resistance against the energy. For example, an epoxy resin, a urea resin, a silicone resin and the like are favorably used. The oxide-coated fluorescent substance particles contained in the fluorescent substance containing glass sheet 11 provided on the top surface of the transparent resin are excited by the light from the LED, and emit wavelength converted light. The wavelength converted light and emitted light from the LED are diffused in the glass sheet and are mixed in color, and white light is emitted from the LED element surface.

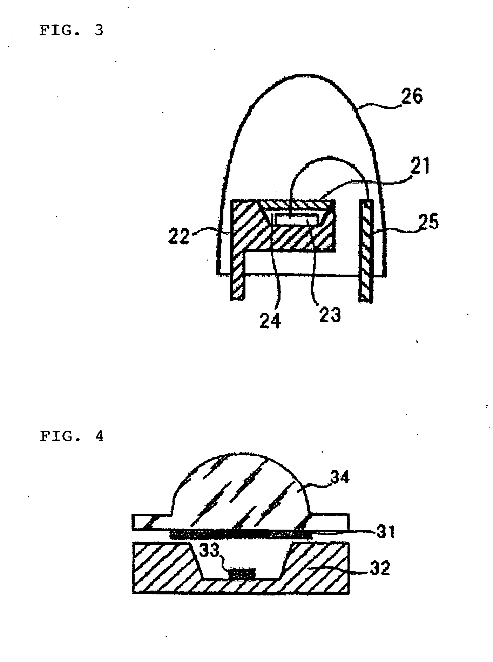

As another example of the light-emitting device of the present invention, the one shown in the schematic view in FIG. 3 can be cited. The light-emitting device shown in FIG. 3 is mainly provided with an LED 23 fixed to a recessed portion on a metal stem 22, a transparent resin 24 provided in the recessed portion to encircle the LED 23, and the above-described fluorescent substance-containing glass sheet 21 to cover the transparent resin. The LED 23 such as a gallium nitride compound semiconductor is electrically connected to a power supply not shown via a metal post 25 connected by wiring, and emits blue/ultraviolet light. Further, a mold resin 26 which molds the metal post and the metal stem on which the LED is mounted is provided.

The transparent resin is provided to protect the LED, and the mold resin has the function of a lens which diffuses the light emitted from the LED element, and as these resins, for example, an epoxy resin, a urea resin, a silicone resin and the like which are excellent in transmitting property of emitted light from the LED and have resistance against the energy are favorably used.

In the light emitting device, the oxide-coated fluorescent substance particles contained in the glass sheet 21 provided on the top surface of the transparent resin are excited by the light from the LED, and emit wavelength converted light. The wavelength converted light and emitted light from the LED are diffused in the glass sheet and are mixed in color, and white light is emitted from the LED element surface.

As another example of the light-emitting device of the present invention, the one shown in a schematic view in FIG. 4 can be cited. A light-emitting device shown in FIG. 4 is mainly provided with a substrate 32 including a recessed portion having a function of a reflector, a LED 33 fixed on a submount (not shown) fixed to a bottom surface of the recessed portion of the substrate, an optical member 34 having a function of a lens on the recessed portion of the substrate provided with the LED 33, and the above-described fluorescent substance- containing glass sheet 31 on an undersurface of the optical member 34 to be opposed to the LED. The LED 33 emitting the above-described blue light can be used. The LED has its electrodes wire-bonded by wiring not shown, and is electrically connected to a power supply not shown, and emits blue/ultraviolet light.

A transparent resin, such as an epoxy resin, a urea resin, and a silicone resin, for example, which are excellent in transmitting property of emitted light from the LED and have resistance against the energy may be provided in the recessed portion of the substrate 32.

In the light-emitting device, the oxide-coated fluorescent substance particles contained glass sheet 31 are excited by the light from the LED, and emits wavelength converted light. The wavelength converted light and the emitted light from the LED are diffused in the glass sheet and mixed in color, the emitting direction is further diffused by the optical member 34, and white light is emitted from its surface.

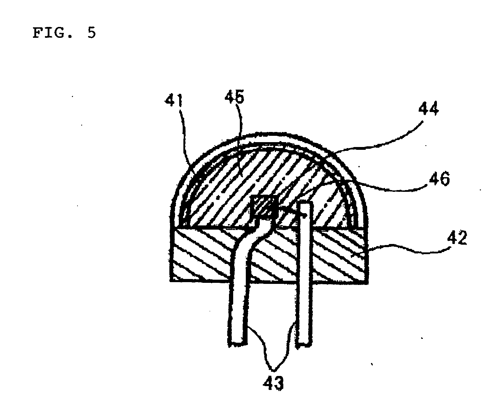

As another example of a light-emitting device of the present invention, the one shown in a schematic configuration view in FIG. 5 can be cited. The light-emitting device shown in FIG. 5 is mainly provided with a substrate 42, a pair of leads 43 fixed to the substrate, an LED 44 fixed on one of the leads, a transparent resin 45 which encircles the LED 44, and the above-described fluorescent substance-containing glass sheet 41 to cover the transparent resin. The LED 44 such as a gallium nitride compound semiconductor which is formed by stacking an InGaN light-emitting layer on a substrate of Al₂O₃ or SIO and emits blue light can be used. The LED is connected to the other lead by wiring 46 and is electrically connected to a power supply not shown and emits blue/ultraviolet light.

The above-described transparent resin is provided for protection of the LED, and for example, an epoxy resin, a urea resin, a silicone resin and the like which are excellent in transmitting property of emitted light from the LED and have resistance against the energy are favorably used.

In the light-emitting device, the oxide-coated fluorescent substance particles contained in the fluorescent substance-containing glass sheet 41 provided on the top surface of the transparent resin are excited by the light from the LED, emit wavelength converted light. The wavelength converted light and emitted light from the LED are diffused in the glass sheet and mixed in color, and white light is emitted from the LED element surface.

### [Exemplary Embodiments]

The fluorescent substance containing glass sheet and the light-emitting device of the present invention will be more specifically described in detail hereinafter, but the technical range of the present invention is not limited to them.

### [Exemplary Embodiment]

Silicon dioxide coating of a thickness of about 500 nm was formed on particles of Eu-activated sulfide the fluorescent substance SrGa₂S₄ each of a particle size of 1 to 30 µm by a solution method. The obtained silicon dioxide-coated SrGa₂S₄ particles were mixed into glass powder with borosilicate glass as a main component so that SrGa₂S₄ was 1.0 mass%, and the mixture was obtained. The obtained mixture was poured into the mold, was heated at 400°C for 0.5 hours, was taken out of the mold, was heated at 500°C for two hours and the glass sheet of a thickness of 0.5 mm was obtained.

The value of the attenuation of the sulfide fluorescent substance containing glass sheet, which was obtained by comparison with the YAG fluorescent substance as described above was about 11.8%.

After the obtained glass sheet was placed under the environment at a high temperature with high humidity for at least 500 hours, the attenuation of the intensity of the wavelength converted light emitted from the oxide-coated fluorescent substance was within 5% as compared with that shortly after forming.

### [Comparative Example]

The glass sheet was produced as in the exemplary embodiment except that silicon dioxide coating was not performed. The value of the attenuation of the sulfide fluorescent substance in the forming process of the glass sheet which was obtained as in the exemplary embodiment was about 40%.

The fluorescent substance containing glass sheet of the present invention can suppress deterioration suffered by the sulfide fluorescent substance from the environment, and deterioration suffered in the forming process, and can be used for a light-emitting device such as an LED element using a blue/ultraviolet light-emitting diode, and the light-emitting device which emits white light with high intensity can be obtained. Further, the light-emitting device which suppresses corrosion of the electrodes and the like of the light-emitting device by the sulfide fluorescent substance, can increase the life of the light-emitting device, and does not bring about environmental pollution by lead can be obtained, and industrial availability is extremely high.

## Claims

1. A fluorescent substance containing glass sheet formed by mixing an oxide-coated fluorescent substance particle with glass powder that does not substantially include lead, and sintering them, the oxide-coated fluorescent substance particle having been produced by coating a surface of a sulfide fluorescent substance particle, which is excited by light emission from a light-emitting element and which emits wavelength converted light, with an oxide,
wherein attenuation of intensity of said wavelength converted light emitted by said sulfide fluorescent substance particle is suppressed by a forming process.

2. Fluorescent substance containing glass sheet according to claim 1,
wherein said oxide includes any one kind or two kinds or more of a silicon oxide, a yttrium oxide, an aluminum oxide and a lanthanum oxide.

3. Fluorescent substance containing glass sheet according to claim 1 or 2,
wherein said sulfide fluorescent substance particle includes any one kind or two kinds or more of SrGa₂S₄, CaGa₂S₄, SrS, CaS, (Sr, Ca, Ba, Mg)Ga₂S₄ or (Sr, Ca, Ba)S activated with Eu.

4. A method for manufacturing a fluorescent substance containing glass sheet, comprising a forming process in which an oxide-coated fluorescent substance particle produced by coating a surface of a sulfide fluorescent substance particle which is excited by luminescence from a light-emitting element and which emits wavelength converted light, with an oxide, and glass powder that does not substantially include lead are mixed and sintered,
wherein attenuation of intensity of said wavelength converted light emitted by said sulfide fluorescent substance particle is suppressed by said forming process.

5. Method for manufacturing a fluorescent substance containing glass sheet according to claim 4,
wherein said oxide includes any one kind or two kinds or more of a silicon oxide, a yttrium oxide, an aluminum oxide and a lanthanum oxide.

6. Method for manufacturing a fluorescent substance containing glass sheet according to claim 4 or 5,
wherein said sulfide fluorescent substance particle includes any one kind or two kinds or more of SrGa₂S₄, CaGa₂S₄, SrS, CaS, (Sr, Ca, Ba, Mg)Ga₂S₄ or (Sr, Ca, Ba)S activated with Eu.

7. A light-emitting device,
wherein said fluorescent substance containing glass sheet is used.
